# EUROPEAN PATENT APPLICATION

(11) **EP 1 089 204 A2**
(43) Date of publication of application: **04.04.2001**
(21) Application number: 00120129.2
(22) Date of filing: 20.09.2000
(51) Int. Cl.: G06F 17/50

(54) **Method for integrated circuit layout**

(30) Priority: 22.09.1999 DE 19945405
(71) Applicant: TEXAS INSTRUMENTS DEUTSCHLAND GMBH, 85356 Freising (DE)
(72) Inventor: Stadler, Walter, 85356 Freising (DE)
(74) Representative: Schwepfinger, Karl-Heinz, Dipl.-Ing.

(57) **Abstract**

In a method for fabricating an integrated circuit on a semiconductor substrate in which various types of circuit modules for the transfer of data and control signals in the circuit are interconnected via a bus conductor system, the bus conductor system is first produced on the semiconductor substrate. The circuit modules are then floor planned on the bus conductor system in accordance with their specific requirements on the transit times of the incoming and outgoing signals and connected to the bus conductor system.

## Description

The invention relates to a method for fabricating an integrated circuit on a semiconductor substrate in which various types of circuit modules for the transfer of data and control signals in the circuit are interconnected via a bus conductor system.

When an electronic circuit is to be fabricated in the form of an integrated circuit, first of all the layout needs to be created, i.e. a floor plan indicating how the individual modules of the electronic circuit are to be located on the available surface area of the semiconductor substrate, after which the individual modules are interconnected by means of a bus conductor system. The layout of this bus conductor system needs to take into account this floor plan so that it enables all circuit modules to be connected.

The above procedures of producing the layout and subsequently creating the bus system as well as connecting the modules to this system are done computer-assisted, requiring computer programs to be available to define floor planning and auto-layout of circuit modules in routing the bus conductor system through the floor plan and connecting it to the circuit modules. On completion of the layout the response of the created circuit is likewise simulated in computer programs, this testing in particular whether the resulting bus conductor lengths are acceptable at the intended working frequencies and do not result in prohibitively high capacitive loads of the individual modules. These capacitive loads to be attributed to the bus line lengths may namely result in the worst case in prohibitively long signal transit times, detrimenting satisfactory functioning of the integrated circuit. Should the simulation program of the created circuit indicate that the response of the circuit fails to come up to expectations, the computer programs currently in use are able to modify the layout in the sense of enhancing the transit time response by taking into account the results of simulation. However, this improvement may not always be to the extent that optimum results are actually achieved, since due to the floor plan only limited means of varying the routing of the bus conductor system and the lengths of the connections are available.

The invention is thus based on the object of providing a method for fabricating an integrated circuit which makes it possible to substantially shorten the conductor lengths and thus to considerably enhance the signal transit time response.

This object is achieved in accordance with the invention by the steps of first producing the bus conductor system on the semiconductor substrate before then floor planning the circuit modules on the bus conductor system in accordance with their specific requirements on the transit times of the incoming and outgoing signals and connecting the circuit modules to the bus conductor system.

In fabricating an integrated circuit in application of the method in accordance with the invention the routing of the bus conductor system on the semiconductor substrate is first defined. It is not until thereafter that floor planning the individual circuit modules is done which can now take into account the requirements of the individual modules as regards the transit time response of the signals by planning modules having a critical transit time response very near to the bus conductor system whilst less critical modules in this respect may be located further away. Configuring the layout in this way makes short conductor lengths possible so that the fabricated integrated circuit can be put to use at high frequencies, i.e. the short conductor lengths reducing the effect of line capacitances on the circuit functions.

Advantageous further embodiments of the invention are characterized in the sub-claims. In the embodiment characterized in the claim 2 the bus conductor system is made up of four bus main branches on a roughly square semiconductor substrate, each running like the arms of a cross from the middle of the substrate to the edges thereof. The surface area of the semiconductor substrate is thus divided into four quadrants in which the circuit modules may be connected to the individual bus main branches in achieving optimum short conductor lengths. The further embodiment characterized in the claim 3 enables the individual bus main branches to be activated or deactived by means of the control circuit connected to all bus main branches so that the overall capacitive load resulting from the bus conductor system active in each case can be reduced, when required.

The invention will now be detailled by way of an example with reference to the drawings in which
- Fig. 1 is a plan view of an integrated semiconductor circuit having a layout produced conventionally, the individual circuit modules being represented only schematically and by way of example,
- Fig. 2 is a plan view of an integrated semiconductor circuit having a layout produced by the method in accordance with the invention
- Fig. 3 is a plan view of an integrated semiconductor circuit having a layout likewise produced by an advantageous further embodiment of the invention.

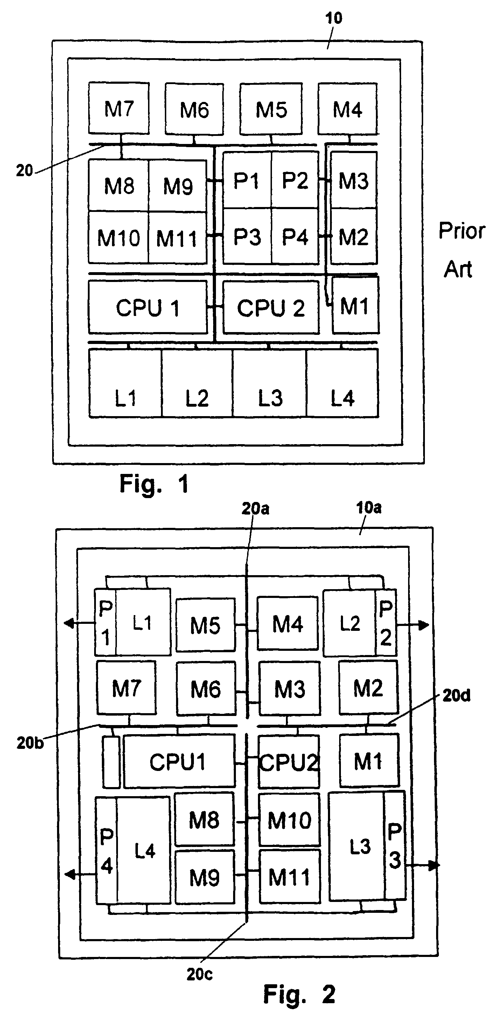

Referring now to Fig. 1 there is illustrated a plan view of an integrated circuit 10 having a prior art layout. It is evident that the floor plan of the various types of circuit modules on the surface area of the semiconductor substrate containing the integrated circuit 10 identifies the functional differences by differing letter combinations, i.e. the integrated circuit containing two central processing units CPU 1, CPU2, memory modules M1-M11, peripheral units P1-P4 and logic modules L1-L4. Once the floor plan of the cited modules on the surface area of the semiconductor substrate has been produced in making use of the conventional auto-layout process, a bus conductor system 20 is produced in the remaining free surface areas, enabling the individual modules to be interconnected and to the central processing units CPU1 and CPU2 as required in each case. The routing of the bus conductor system materializes from the floor plan of the circuit modules. The bus conductor system can only be arranged in the interspaces remaining between the modules, i.e. there being no possibility of shortening the conductor lengths at will.

Due to the capacitance of the connecting conductors the conductor lengths are a substantial factor in defining the maximum frequency at which the circuit as created can operate.

Referring now to Fig. 2 there is illustrated a plan view of an integrated circuit 10a whose layout is configured in application of the method now to be described. In making use of this method first the bus conductor system is produced on the semiconductor substrate 10a, this system comprising four bus main branches 20a, 20b, 20c and 20d. Two each of these main branches are floor planned in a line halving the opposing edges of the semiconductor substrate 10a, i.e. the bus main branches forming, as evident from the plan view in Fig. 2, a symmetrical cross, the arms of which extend from the middle of the semiconductor substrate to the edges thereof. Once this bus conductor system has been produced, the circuit module are floor planned so that the connections between the individual bus main branches and the terminals of the circuit modules materialize as short as possible. In this arrangement care is taken in particular to ensure that the circuit modules placing particularly high requirements on the transit times of the signals incoming and outgoing therefrom are located particularly near to the bus main branches. Circuit modules of this kind are, for example, the central processing units CPU1 and CPU2 as well as the memory modules M1-M11. As evident from Fig. 2 the connections between these modules and each of the bus main conductors are very short so that the line capacitances of these short connections have no serious effect on the signal transit times. The integrated circuit thus created may be operated at substantial higher frequencies than the integrated circuit as shown in Fig. 1.

In the integrated circuit as shown in Fig. 2 the circuit modules, which as regards the signal transit times are uncritcal, are located further away from the bus main branches, these modules in the example as described being the peripheral units P1-P4 and the logic units L1-L4.

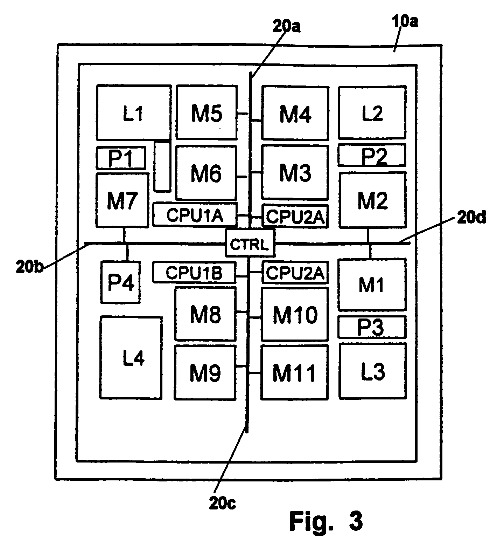

Conventionally in an integrated semiconductor circuit the whole bus conductor system is active, i.e. connected to the circuit modules so that these receive the full line capacitance of the conductor system. Referring now to Fig. 3 one advantageous further embodiment of the method as described herein will now be detailled. Formed on the semiconductor substrate is a control circuit CTRL which in the example as shown is located in the center portion of the integrated circuit and is connected to each of the bus main branches. This control circuit CTRL is able to activate or deactive the individual bus main branches 20a-20d by means of the control signals as a function of whether the circuit modules connected to each bus main branch concerned is needed or not for an action in the integrated circuit. Deactivation results in the bus main branches connected to circuit modules not required being decoupled from the circuit modules and bus main branches needed for the functioning being implemented at the time. The deactivated bus main branches thus produce no capacitive loading of the active modules so that these are able to operate accordingly at higher frequencies.

It will readily be appreciated that the method as described may also be implemented, of course, in making use of the computer programs for the auto-layout of that shown by way of example in Figs. 2 and 3 in taking into account the response of the integrated circuit needed. One such computer program used for this purpose first needs to define the bus conductor system, however, in accordance with the method as described, so that then an optimum floor plan of the circuit modules is attainable in achieving conductor lengths as short as possible.

## Claims

1. A method for fabricating an integrated circuit on a semiconductor substrate in which various types of circuit modules for the transfer of data and control signals in the circuit are interconnected via a bus conductor system, comprising the steps of first producing the bus conductor system on the semiconductor substrate before then floor planning the circuit modules on the bus conductor system in accordance with their specific requirements on the transit times of the incoming and outgoing signals and connecting the circuit modules to the bus conductor system.

2. The method as set forth in claim 1 wherein said bus conductor system is made up of four bus main branches on a roughly square semiconductor substrate, two each of said main branches being floor planned in a line halving the opposing edges of said semiconductor substrate, and wherein said circuit modules are then connected to one of said bus main branches in achieving the shortest conductor length in each case.

3. The method as set forth in claim 2 wherein a control circuit connected to all bus main branches is applied to said semiconductor substrate, said control circuit activating or deactivating individual bus main branches as required by control signals furnished by the control.
